# EUROPEAN PATENT APPLICATION

(11) **EP 4 144 893 A1**
(43) Date of publication of application: **08.03.2023**
(21) Application number: 21461583.3
(22) Date of filing: 06.09.2021
(51) Int. Cl.: C30B 7/10, C30B 29/40

(54) **A METHOD FOR REDUCING OR ELIMINATING CRACKS DURING CRYSTAL GROWING PROCESS AND A SHAPED METAL PIECE FOR USE IN THIS METHOD**

(71) Applicant: Instytut Wysokich Cisnien Polskiej Akademii Nauk, 01-142 Warszawa (PL)
(72) Inventor: Grabianska, Karolina, 04-349 Warszawa (PL); Kucharski, Robert, 03-289 Warszawa (PL); Bockowski, Michal, 01-684 Warszawa (PL); Puchalski, Arkadiusz, 05-311 D be Wielkie (PL)
(74) Representative: AOMB Polska Sp. z.o.o.

(57) **Abstract**

The present invention relates to a method for providing crack-free growth of crystals, wherein a shaped metal piece is placed over the crystal area having increased crack-forming potential, in such a way that the metal piece fully covers the mentioned area. The present invention relates also to a shaped metal piece used in this method.

## Description

The present invention relates to a method for reducing or eliminating cracks during crystal growing process and to a shaped metal piece for use in this method.

### State of the art

There are many crystal growth methods which employ the use of crystal seeds, used to initiate the crystallization process in specific conditions.

One of the known methods is ammonothermal growth, which includes dissolving the feedstock in supercritical ammonia in the first of two zones of a high-pressure autoclave. The dissolved feedstock is transported to the second zone, where the solution is supersaturated and crystallization on native seeds occurs. An appropriate temperature gradient between the dissolution (dissolving) and crystallization (growth) zones enables the convective mass transport. In order to accelerate and enhance the solubility of feedstock, some mineralizers are added to the reaction zone. Depending on the type of used mineralizers, the ammonothermal crystal growth can be either basic or acidic. In the ammonoacidic approach, halide compounds (with NH₄⁺ ions) are introduced into the supercritical solution, while in case of the ammonobasic crystallization alkali metals or their amides (with NH₂⁻ ions) are used.

Ammonothermal method can be used to grow various crystals including for example aluminum nitride (AIN), indium nitride (InN) and GaN.

The idea of the basic ammonothermal growth of GaN crystals is generally as follows. Polycrystalline GaN, used as a feedstock, is dissolved in supercritical ammonia in one zone of the reactor. The dissolved material is then transported to the second zone, where the solution is supersaturated and the crystallization of GaN takes place on native seeds. The seeds are mainly ammonothermally-grown GaN crystals.

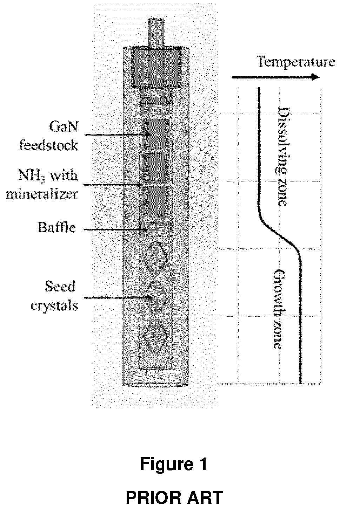

In this type of method a negative temperature coefficient of solubility is observed. As a consequence, the chemical transport of GaN is directed from the low-temperature solubility zone (with feedstock in a crucible) to the high-temperature crystallization zone (with seeds). The GaN feedstock is arranged in the upper part of the reactor and the GaN seeds are placed on special holders in the lower part of the reactor. These two zones are separated by baffles. All of the elements inside the autoclave (reactor) are made of high purity metals. A scheme of the basic ammonothermal GaN crystallization method is presented in Fig. 1, where the GaN feedstock in the crucible is located in the upper part of the autoclave and GaN seed crystals are located in the lower part of the autoclave. This figure also presents the temperature distribution.

Another crystal growth method is halide vapour phase epitaxy (HVPE) in which the crystal precursor is formed in situ, i.e., in the reaction zone. The reactor is also divided into two zones - source zone and growth zone. For example, in order to produce GaN crystals (or other crystals, such as GaAs or InP) with this method, in the first reaction zone (source zone) group-III metal, such as gallium, is reacted with hydrogen chloride to produce gaseous metal chloride. This gaseous metal chloride reacts further in the growth zone of the reactor with ammonia. In this growth zone of reactor, a seed zone can be distinguished in which a suitable crystal seed is placed on a special holder. Due to a reaction of gaseous metal chloride with ammonia, group-III nitride is produced and it grows in the seed zone, increasing the seed's size. This way crystals of gallium nitride can be obtained. The main advantage of this method is a high rate (exceeding 100 µm/h) of crystal growth and high crystal purity. The main limiting factor of the HVPE growth is parasitic deposition: GaN grains crystallize on all elements of the reactor. The accumulation of parasitic deposits increases with the duration of the growth process. GaN grains can nucleate on the reactor's elements and fall onto the growing crystal, forming pits, cracks, and other defects. A strong nucleation of polycrystalline GaN reduces the flow of the metal chloride over time. Therefore, the growth rate can also be affected.

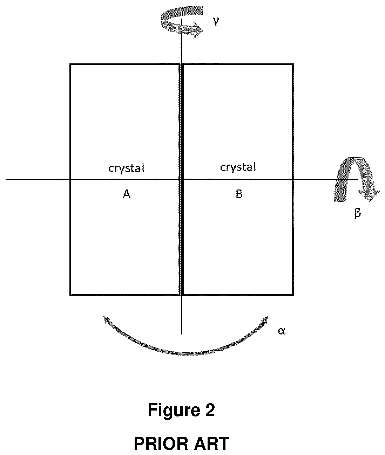

Until now in order to achieve a crystal of a desired, increased lateral size, smaller crystal seeds were tiled into one larger by placing them next to each other. This approach is schematically presented in Fig. 2. In this tiling method, the seeds (tiles) (A & B) are misoriented properly in three crystallographic directions and are placed in a specially designed holder (not shown). The holder is further inserted into an autoclave (or any suitable reactor) in order to perform crystal growth.

A proper mutual misorientation of the seeds in three planes, as presented in Fig. 2, allows to obtain crystals in which the angular differences of α, β, and γ are smaller than 0.02°. The main disadvantage of such an approach to tiling crystals is the appearance of stress in the material crystallized in the area of the tiling seam. This often results in the occurrence of many cracks in crystals present mostly above the tiling seam.

US Patent Application No. US20190249333A1 relates to forming bulk GaN crystals and wafers starting from seed with multiple dislocations and obtaining new crystal having 10% or even less of those dislocations. The method disclosed in this document comprises providing a metal mask on the seed, preferably in a form of dot-like masks, which prevents propagation of dislocations during ammonothermal growth of GaN crystals. This metal mask is formed by: first etching the seed's surface, then depositing metal (such as silver, nickel, vanadium, and platinum or any other metal which can withstand corrosion in ammonothermal conditions) on the seed's surface and inside the seed's dislocations, and finally, after obtaining a planar metal layer on top of the GaN seed, removing the uppermost metal layer in order to expose the GaN seed and planarizing the surface. In this way, bare seeds with dislocations filled with the metal are obtained, and those dislocations appear as metal dots on the seed's layer. Such a newly obtained crystal with metal filling is used as a seed for ammonothermal growth of bulk GaN crystals. The growth is continued at least until the metal masks are covered with a newly grown crystal and a bulk GaN crystal of a low dislocation density is obtained. The cracks appear only in the areas where the dislocations were not filled with the metal mask. This method is used to eliminate dislocations only in a single crystal and the disclosure in this document does not provide any guidance to use this method for increasing the lateral size of a crystal. On the contrary, the dot-like masks suggest that the dislocations are point-like and are not present on the area of joining two seeds.

US Patent Application No. US5377615A relates to a process of increasing the lateral size of quartz crystals using a plate assembly method (tiling). The method used for growing the crystal on the seed comprised of several assembled seed plates is for example hydrothermal growth. Those seed plates have identical length and/or width but can be of different thicknesses. They are connected together on a support by guidance elements, which ensure a proper alignment of the plates. While creating a seed assembly, the plates are properly aligned, put together and tightened. The structure is then covered with silver or gold lacquer and baked to ensure its rigidity. The purpose of those metal layers is to solidify the plate structure and maintain plates orientation, and they are not used to eliminate propagation of cracks in the growing crystals.

US Patent Application No. US20120252191 A1 describes a method for producing a GaN semiconductor, in which a crystal silicon layer is bonded to a transparent substrate and GaN crystal is grown on the silicon layer. A single silicon layer is made of several silicon tiles with seams between them. At least some of those seams are filled due to lateral epitaxy with a GaN layer growing on top of the silicon layer. This method of growth leads to formation of a single, integrated GaN layer with a reduced dislocation density.

US Patent No. US10301745B2 discloses a method for obtaining ultralow-defect gallium-containing nitride crystals. In said method two gallium nitride crystal grow (for example by ammonothermal growth) next to each other both in lateral and vertical direction until they merge with each other and form one single crystal. Lack or low number of dislocations is achieved thanks to very low crystallographic misorientation between nitride crystals. No additional means, such as shaped metal piece are used.

US Patent No. US10655244B2 also refers to growing gallium nitride crystals using tiling method. In this document it is disclosed that during crystal growth through cracks tend to appear on linear regions of high dislocation density, which may correspond to the regions of connection of adjacent crystal tiles. In order to eliminate the appearance of those through crack, the tiles were precisely aligned with respect to each other and the roll-off of their edges was reduced.

US Patent No. US6805745B2 also discloses a method for growing large size, single crystals using tiling of adjacent crystal seeds. In order to obtain a large crystal, smaller crystal seeds are assembled together so as to minimize gaps between them, and the growing process is carried out. In order to minimize defective growth, tiles are cut and fitted to closely match each other in the seed assembly. To this end, crystal wafers are mechanically polished, diced, and assembled on the seed holder using an adhesive, which further ensures their correct alignment. The obtained structure is heated, pressed until bonded and used for further crystal growth process.

Based on the above prior art it is evident that there is a need for a method which would enable crack-free growth of crystals having increased lateral size due to the use of crystal tiling method. Such a method should be simple and should allow for obtaining a crack-free crystals in an optimal manner. Unexpectedly, the present invention fulfils not only the above mentioned needs, but it has also proven useful in growing crack-free crystals using non-crack-free crystal seeds as a growth substrate.

### Subject of the invention

The technical problem outlined above is solved by a method as defined in appended claim 1 and by the shaped metal piece as defined in appended claim 12.

### Advantages of the invention

The method of the invention allows for growth of crack-free crystals both in a simple growth process involving the use of a single, non-crack-free crystal seed, as well as in a crystal tiling method. Both variants employ a shaped metal piece which is placed over the surface with cracks in case of single crystal seed or over the joint line of adjacent crystal tiles in such a way that it covers the whole area having increased crack-forming potential. Said shaped metal piece is constructed in such a way that it does not introduce additional stress in the new-grown crystal during crystal growth and during cooling down of the reactor at the end of the growing process. This is due to a suitable choice of shape, presence of a void inside the metal shaped piece or between the shaped piece and the surface of the crystal seed, as well as materials for producing the metal shaped piece.

The shape of this shaped metal piece limits the growth in the [11-20] crystallographic direction, it does not introduce additional stress inside the crystal and therefore prevents the appearance of cracks into the new-grown crystal. When it is used in a tiling method, said shape can be adapted in such a way that the tiling of the seeds appears on a narrow seam area (a few hundred micrometers width) and this area moves in time without increasing its lateral size when the crystal is grown in the [000-1] direction.

Furthermore, the void inside the shaped metal piece itself or created between the shaped metal piece and the surface of the crystal seed allows to release the stress in the new-grown crystal and, therefore, prevents from the formation of cracks.

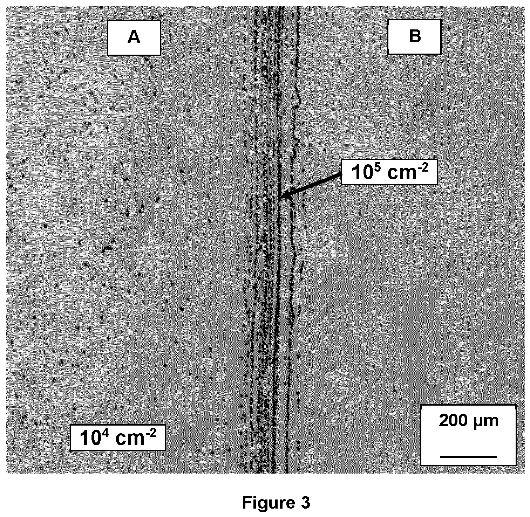

Such an approach allows to obtain both simply crack free-crystals and crystals having increased lateral size and extremely high structural quality. The etch pit density correlated with the threading dislocation density is in both cases at the level of 10⁴ cm⁻², while in case of crystal tiling method, the etch pit density in the tiling seam area can be higher by one order of magnitude. This is presented visually in Fig. 3, where the etch pits obtained after chemical etching performed on the tiled crystals are shown. The etching was performed using base solution (KOH/NaOH) at 500°C for 30 minutes. In turn, the method of the invention provides that the appearance of cracks on the tiling seam area of the seeds is strongly limited or even completely prevented.

The location of placement of the shaped metal piece is also essential for achieving such results, however it is important to notice that besides the correct placement, adjustment and appropriate choice of the shape, no additional pre-treatment of the seed(s) or no special crystal growth conditions are required. The proper application of shaped metal piece prevents the propagation of cracks from the seed to the new-grown material by itself.

Another important feature of the subject invention is that the materials used for the construction of the shaped metal piece were selected according to their resistance to the conditions of the ammonothermal process. Thanks to that no additional reactions or corrosion can appear. Moreover, those materials do not introduce additional stress in the growing crystal. Furthermore, those materials are elastic to a certain degree, thus even further reducing the stress in the growing crystal. Last but not least, the chosen materials do not introduce any impurities to the growing crystals.

### Drawings

Figure 1 shows a scheme of basic ammonothermal GaN crystallization known from the prior art, in which GaN feedstock in the crucible is in the upper part of the autoclave and GaN seed crystals are in the lower part of the autoclave. The temperature distribution is also presented in this figure.

Figure 2 shows a scheme of tiling two crystals to obtain one larger crystal. Three important misorientation angles: α, β, and γ, are marked.

Figure 3 shows surfaces of two tiled crystals A and B after chemical etching performed to visualize the etch pits correlated to dislocations in the crystal area and the tiling seam.

Figure 4 shows exemplary cross-section shapes of shaped metal piece according to the invention.

Figure 5 shows, in schematic manner, tiling of two crystals A and B according to the prior art: a) before crystal growth process; b) after crystal growth process.

Figure 6 illustrates, in schematic manner, the crystal growth process according to the invention with the use of metal shaped element in two variants: a) tiling of two crystals A and B; b) growing crack-free crystal on the crystal seed with dislocations.

Figure 7 shows, in schematic manner, two different methods of placement of shaped metal piece and the resultant grown crystal.

Figure 8 shows an illustration of: a) the crystal seed with cracks; and b) results obtained by performing crystal growth on this crystal seed without metal shaped element (according to Example 1).

Figure 9 shows an illustration of: a) the crystal seed with cracks t; b) the same crystal seed with cracks covered with a single shaped metal element before crystallization; and c) results obtained by performing crystal growth on this crystal seed with the metal shaped element (according to Example 2).

Figure 10 shows an illustration ((a) photograph, b) schematically), of the results obtained by performing crystal growth using tiling method without metal shaped element (according to Example 3).

Figure 11 shows an illustration, ((a) photograph, b) schematically), of the results obtained by performing crystal growth using tiling method with a metal shaped element (according to Example 4).

### Detailed description of the invention

### General information

Basically, for a square crystal seed there are three main planes in which crystal may grow i.e., m-plane, a-plane (both correspond to lateral growth) and c-plane (corresponds to vertical growth). Those planes can be connected with several crystallographic directions of the growth. In case of crystal growth process, the main lateral growth directions are: [10-10] in m-plane and [11-20] in a-plane. Vertical growth in c-plane can proceed in [000-1] direction (upward direction) or in [0001] direction (downward direction). The crystal growth in any of the above directions can be connected with tensions, stress and therefore appearance of cracks.

The aim of the invention is to provide a method of preparing crack-free crystals using a crystal seed with cracks. Further aim of the invention is also to grow crack-free crystals having increased lateral size using crystal tiling method.

To achieve these goals, the method of the invention employs a shaped metal piece(s) placed on the crystal seed over the area having increased crack-forming potential, in such a way that the metal piece covers the whole area.

The term "*area having increased crack-forming potential*" as used herein refers to a region of the crystal or crystal seed which contains defects such as cracks or is prone to develop such defects for example during any step of crystal growth process.

In the context of the present invention the area having increased crack-forming potential is an area, which can lead or leads to forming defects in the growing crystal. Such an area can be a crystal surface comprising defects, such as puncture recesses, scratches, grooves, cracks, holes, pits or any other imaginable defects; or a joint line of two or more separate crystals, which are intended to be merged by crystal tiling method. In this description terms such as 'defects', 'cracks', 'dislocations', 'damages' are meant to be synonymous and can be used interchangeably.

The term "*crystal seed*" as used herein is used in its normal meaning and refers to a single crystal, used in crystal growth process to start a growth of a larger, target crystal.

The term "*reducing or eliminating cracks*" as used herein refers to a result of the method of the invention and means either a complete elimination (100%) of the defects or dislocations present in the crystal seed or a reduction of their number preferably by at least 50%, more preferably at least 60%, even more preferably by at least 70%, in particular by at least 80%, for example by at least 90%, especially by at least 95%, most preferably by at least 99%.

### Method of the invention

In the first step of the method of the invention, the shaped metal piece, as described above is placed on a crystal seed over the area having increased crack-forming potential. The shaped metal piece is adjusted in such a way that it releases the stress in the newly grown crystal and therefore prevents the formation of cracks. In the next step a single crystal seed or tiled seeds equipped with the metal piece(s) is placed in the reaction zone along with other necessary substrates and finally the growth process is carried out.

As described above, providing the shaped metal piece with the void enables to perform a controllable and gradual misorientation of the tiled crystals by crystallization in the [000-1] crystallographic direction. Due to the specific construction of this shaped metal piece, the crystal growth proceeds with no additional stress applied to the growing crystal. After the growth process is complete, the reaction zone is cooled down, which in normal conditions would result in increased stress in the grown crystal due to a difference in thermal expansion between the crystal and the metal piece. However, again, the void in the metal piece serves as a buffering element and reduces the tension, thus leading to obtaining a newly grown, crack-free crystal.

The second part of eliminating stress in the crystal during the cooling down of the reactor is connected with proper mounting of the crystals in the reactor by means of elastic elements. The flexibility of these elements allows for small movement resulting from the difference in the thermal expansion of the growing crystal and the elastic element. On the other hand, the element has to be stiff enough to preserve the original misorientation of the tiled crystals. The element used for mounting is made from Ag, Ni or Ni-Cr alloys.

In all of the above-described steps and procedures one needs also to remember that the crystal cannot overgrow the metal piece, since this will lead to creating an inelastic system vulnerable to cracking.

It is important to point out that the method of the invention may be used to modify any crystal growth process in which crystal seeds having areas with increased crack-forming potential are employed. In the preferred embodiments, the method of the invention is used to modify ammonothermal or HVPE process, but the scope of the invention is not narrowed to these two techniques.

As described above, in the ammonothermal method crystals are grown in a crystallization zone on special seed holders, on which seeds are placed before starting the reaction. The other part of the reactor, the dissolution zone, comprises polycrystalline feedstock and ammonia with mineralizer. During the course of the reaction, the feedstock is dissolved in supercritical ammonia in the dissolution zone and is transported through a baffle between those two zones to the crystallization zone, where it crystallizes on seed(s). In order to obtain a crack-free crystal growth, the seed(s) can be additionally equipped with shaped metal piece(s) as described above. If more than two crystals are used in the tiling method, the number of the shaped metal pieces can be adjusted, respectively. The conditions for such ammonothermal growth are as follows: temperature ranging from 720 K to 920 K; ammonia pressure of 0.15-0.45 GPa.

Another method, which can be used to grow a desired crystal is for example HVPE. In this method hydrogen chloride is reacted at elevated temperature with the group-III metals to produce gaseous metal chlorides, which then react with ammonia to produce the group-III nitrides. This last step proceeds in a growth zone of the reactor on the seed(s), more specifically in a designated seed zone. As the reaction proceeds, the crystal grows on the seed(s) leading to obtaining a newly-grown crystal. Placing shaped metal piece over this seed(s), as described above, enables to obtain crack-free crystals. The conditions used for growth using this method were as follows: ambient pressure; temperatures of about 750-1300 K.

Furthermore, the method of the invention may be employed with reference to any crystal seeds having areas with increased crack-forming potential, but preferably it is used to in relation to GaN crystal seeds, GaAs crystal seeds, or InP crystal seeds, most preferably GaN crystal seeds. Positioning of the shaped metal piece has to be adjusted to the crystallographic directions characteristic for growth.

As stated hereinabove and hereinbelow, the method of the present invention may be employed in a process of crystal tiling. In such embodiment, the method of the invention comprises the following steps:
(a) laterally tiling together two or more crystal seeds until a desired size of the newly grown crystal is obtained;
(b) symmetrically placing shaped metal piece(s) over the joint line(s) of the adjacent crystal tiles;
(c) introducing the tiled crystal seeds to the reactor;
(d) carrying out the crystal growth process until the desired crystal height is obtained.

In another embodiment, the method of the present invention may be employed in order to eliminate crack propagation from a single, non-crack-free crystal seed to a newly grown crystal. In such embodiment, the method of the invention comprises the following steps:
(a) placing the shaped metal piece over the dislocations present on the crystal seed;
(b) introducing the crystal seed to the reactor;
(c) carrying out the crystal growth process until the desired crystal height is obtained.

The crystals grown using this method can reach 2.3 inches in diameter, but this is not the upper limit for the method of the invention. The lateral size of the crystals is connected to the size of the available seed crystals or the number of tiled crystals (seeds).

### Properties of the shaped metal piece

A *'shaped metal piece', 'metal piece'* or *'shaped piece',* in the context of the present invention, means a manufactured, preferably elongated, metallic element of a pre-defined shape. The main and obligatory element of the shaped metal piece is an upper convex part. When in use, the shaped metal piece comprising the upper convex part looks like a trough placed upside-down. The upper convex part of the shaped metal piece may have various cross sections such as semi-spherical, triangle, polygonal, rectangular, arced, curved as well as complex cross sections being combinations of mentioned simple shapes, preferably semi spherical or triangle.

In some embodiments of the present invention, the shaped metal piece comprises an essentially flat bottom part, connected, preferably integral, with the upper convex part. As a result of this connection, the upper convex part and the essentially flat bottom part of the shaped metal piece form pipe-like structure having a gap extending at least partially in the flat bottom part. The internal volume of the pipe-like structure defines an inside void. The gap in the flat bottom part of the pipe-like structure connects the inside void with the surrounding environment. In certain embodiments, the shaped metal piece is also open on at least one of its ends. In another embodiment, the upper convex part and the essentially flat bottom part of the shaped metal piece form pipe-like structure with no gap in the essentially flat bottom part flat. Such shaped metal sheet however may be used in the method of the present invention only if it is wrapped with metal foil as described in detail herein below.

The term *"essentially"* used herein in reference to the bottom flat part means that the said bottom flat part may be either ideally flat and horizontal or it may deviate from the horizontal direction by +/- 5 degrees, preferably +/- 2 degrees, more preferably by +/-1 degree.

As mentioned above, in some embodiments of the invention the inside void is an inner, empty space defined by the walls of the shaped metal piece, i.e., by the upper convex part and the essentially flat bottom part. In other embodiments of the invention in which the shaped metal piece consists of the upper convex part only, the inside void is defined upon placement of the shaped metal piece, by the said upper convex part and the surface of the crystal seed. Based on the experiments, the present inventors have found that changing the volume or shape of the void with reference to the shape of the metal piece has no influence on the growth process.

The purpose of the inside void is to release stress in the crystal, especially during cooling down of the reactor after the growing process. This function is fulfilled despite the difference in thermal expansion of crystal and metal.

In other preferred embodiments of the invention, the shaped metal piece comprises a substantially vertical protrusion, extending vertically downwards from the essentially flat bottom part. The term *"substantially"* used herein in reference to the vertical protrusion means that said protrusion may deviate from the vertical direction by +/- 5 degrees, preferably +/- 2 degrees, more preferably by +/- 1 degree. The purpose of the substantially vertical protrusion is to separate the crystal seeds when method of the invention includes crystal tiling. In such embodiment, the substantially vertical protrusion is at least partially inserted between the said crystal seeds.

The term "*at least partially"* used herein means that the substantially vertical protrusion is inserted between the crystal seeds either along the whole of the length of the shaped metal piece or along a part of it. It may also mean that the depth on which the vertical protrusion is inserted between the crystal seeds may vary along the length of the shaped metal piece. The size of the substantially vertical protrusion may be within the range from 0.5 mm to 2 mm, preferably 1 mm.

Alternatively, in one embodiment of the method of the present invention concerning a crystal tiling method, the tiled crystals are separated not by the substantially vertical protrusion of the shaped metal piece but by at least one layer of foil, which is wrapped around the whole metal piece and shaped to form a separating part. In another preferred embodiment the shaped metal piece with a the substantially vertical protrusion is wrapped around with a metal foil and thus the tiled crystals are separated by a sheet-foil composite. Preferably, the metal foil used in the method of the invention is 4N silver foil or 3N nickel foil.

Separation of the crystal tiles by one of the technical means as described above results in appearance of crystal seam not between, but above said crystal tiles. Therefore, the correct placement of this shaped metal piece strongly limits or even eliminates the appearance of cracks on the tiling seam area of the crystal seeds.

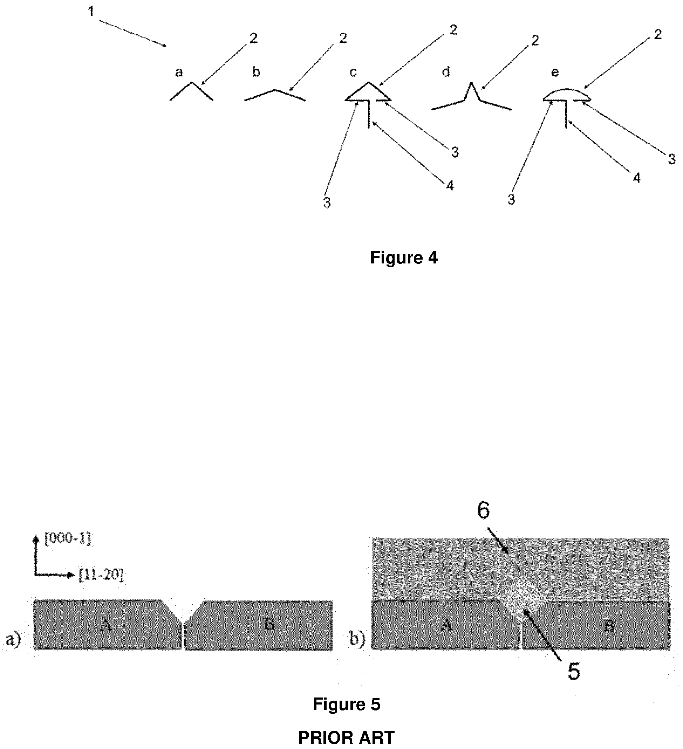

Exemplary shapes of the shaped metal piece cross-sections are illustrated in Fig. 4. First (a), second (b) and fourth (d) exemplary shaped metal pieces (1) presented in the said figure consist of essentially only upper parts (2) having triangle cross section (first two exemplary shapes) or more complex cross-section being a combination of triangle and semi spherical shapes (fourth exemplary shape - d)). Third (c) and fifth (e) exemplary shaped metal pieces (1) comprise also essentially bottom parts (3) as well as substantially vertical protrusions (4). In both cases the essentially bottom parts (3) are connected with the respective essentially flat upper parts (2) in two points, forming horizontal, flat base with a small gap in the middle. Also in both cases, substantially vertical protrusions (4) extend downwards from the essentially bottom parts near the mentioned gap.

Of course, the scope of the invention is not narrowed to the discussed exemplary shapes presented in Fig. 4. In fact, the method of the invention includes the use of a metal shaped piece of any shape or cross-section, provided that it contains at least a convex upper part and, optionally, essentially flat bottom part and substantially vertical protrusion. A skilled person is able to design such shapes of the metal shaped piece without departing from the scope of the present invention.

The discussed shapes of the shaped metal piece, especially shapes of the upper convex part, are crucial for the construction of the metal piece, since they limit the crystal growth in lateral directions, in the same time reducing stress in the growing crystals.

The dimensions of the shaped metal piece are varied depending on their intended use. Briefly, the cross-sectional shape of the metal shaped piece can be either constant or varied along its length.

In an embodiment of the invention, in which the shaped metal piece is used in a crystal tiling method, the length of the shaped metal piece is equal to the lateral size of the tiled seed crystals, while its height is constant and preferably equal to approximately from 0.1 mm to 2 mm, preferably 1 mm. Its width is also constant, and it is in the range of approximately from 0.1 mm to 2 mm, preferably from 0.5 mm to 1.5 mm. Thus, the cross-sectional shape of the shaped metal piece remains unchanged along its entire length.

In the second embodiment, in which the shaped metal piece is used for eliminating the propagation of cracks e.g., in single crystals, the length of the shaped metal piece corresponds to the length of the area of the crystal where the defects (i.e., cracks etc.) are located, while its width can vary in order to correspond to the width of said defective area, e.g., within the range of approximately 1.5 mm to 10 mm. The height of the shaped metal piece can also vary, which means that its cross-sectional shape will change along its length. The angle between the side walls of the shaped metal piece and its bottom may also change corresponding to the width - the wider the metal shaped piece, the smaller the angle. Furthermore, preferably the dimensions of the metal piece should be decreased as much as possible in the parts close to the m-facets of the crystal. In these areas, the width should preferably not be larger than approximately 0.02 mm to 1 mm and the height should not be larger than approximately 0.1 mm to 2 mm. This way the formation of m-facets, which decrease the size of the crystal, will be limited.

The above-described shaped metal piece can be made from materials selected according to their resistance to the conditions of the crystal growing process (e.g., ammonothermal process, HVPE process or any other conditions in which they are intended to be used), so that no additional reactions or corrosion appears. Moreover, those materials should be of high purity in order not to introduce any contamination to the reaction solution and to the growing crystals. Preferably, said materials are selected from a group including nickel, silver, molybdenum, titanium, tungsten and metal alloys selected from a group including Ag-Cu, Ag-Ni, Ag-Ti, Cu-Ni, Cu-Ti, Ni-Ti.

Structurally, the metal piece can be shaped from metal sheet or metal foil or both with a thickness from 0.01 mm to 0.3 mm, preferably from 0.03 mm to 0.1 mm.

In a preferred embodiment of the invention a composite shaped metal piece made of nickel (Ni) sheet wrapped in silver (Ag) foil was used. In another preferred embodiment, composite shaped metal piece made of molybdenum (Mo) sheet was used instead of nickel one and similar results were obtained. In general, the presence of foil enables to achieve crystal of higher quality, since the foil is more flexible than the shaped element itself and thus it introduces fewer defects to the growing crystal than it is in case when the crystal is in direct contact with the metal shaped element. Therefore, it is preferable that the crystal is not in contact with the metal shaped element, but with the foil. Thus, in a most preferred embodiment the metal shaped element is wrapped in foil.

Preferably, the foil used to wrap around the shaped metal piece is made from metal selected from group including Ag-Cu, Ag-Ni, Ag-Ti, Cu-Ni, Cu-Ti, Ni-Ti.

In yet another embodiment of the invention a similar composite shaped metal piece with no void inside was used (i.e. the shaped metal piece did not contained the essentially flat bottom part). Even though the void was lacking, this construction significantly decreased the stress in the growing crystal due to the presence of the foil.

Preferably, the surface of the shaped metal piece should be as smooth as possible. The maximal smoothness of the surface will prevent the spontaneous nucleation of parasitic crystals on the shaped metal piece, which could lead to additional stress in the growing crystal when ingrowing into its structure. Therefore, the metal used in the invention is preferably subjected to pre-processing by rolling or any other smoothing treatment before use.

### Positioning and adjustment of the shaped metal piece

Fig. 5 illustrates the crystal growth process including crystal tiling as known from the prior art. As illustrated, two crystal seeds (A, B) are placed next to each other (a) and undergo a growth process (b) resulting in the creation of a tiling seam 5, i.e., crystal grown in the [11-20] crystallographic direction and formation of cracks 6 in the crystal grown in the [000-1] crystallographic direction above the tiling seam 5.

Thus, one of the most important steps in performing the method of the present invention is the correct placement of the shaped metal piece as it allows to reduce or eliminate the propagation of cracks from the seed to the newly grown crystal.

To this end, the first condition to be fulfilled is the assembly of the shaped piece in a strictly defined manner, i.e., perpendicular to the crystallographic [10-10] plane. More specifically, especially during the process of tiling, the metal piece must be placed in such a way that the axis along which its length is measured is parallel to the [11-20] plane of the seed crystals. The maximum angle between this axis and the [11-20] plane of the crystals is 2° (degrees). Such an assembly and properties of the shaped metal piece itself allow to limit the crystallization in the [11-20] direction. This, in turn, results in less stress and therefore less crack formation in the area having increased crack-forming potential. This way the propagation of cracks from the seed to the crystal grown on it is stopped.

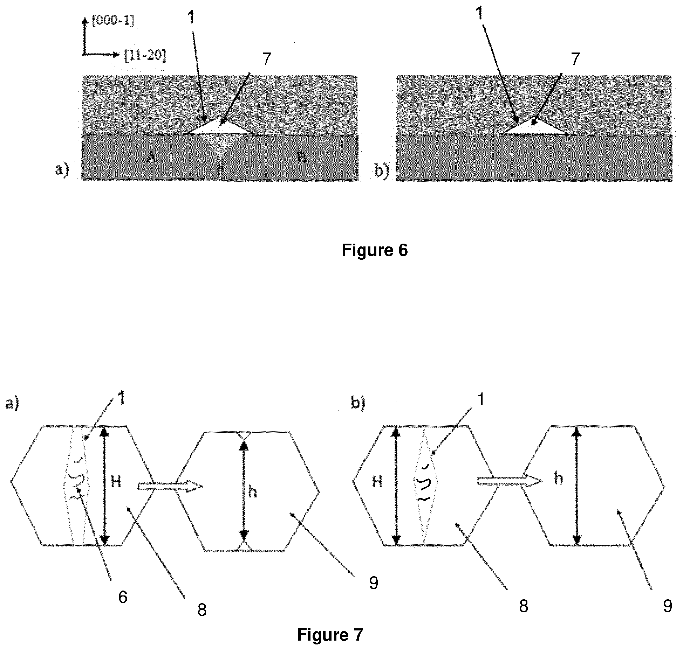

The placement of the shaped metal piece according to the method of the invention and the resulting technical effects are presented in Fig 6. Fig 6a illustrates a growth process including crystal tiling in which two crystal seeds A, B are placed next to each other (a) and undergo a growth process. However, in contrary to the process known from the prior art, before starting the growth process, a shaped metal piece (1) with inside void (7) is placed on the crystal seeds, directly above the gap between the crystal seeds. The shaped metal piece (1) has a small gap in its lower part contacting the crystal (not shown). The placement of the shaped metal piece reduces or prevents crystal growth in the [11-20] crystallographic direction and eliminates the formation of cracks in the crystal grown in the [000-1] crystallographic direction above the tiling seam.

Fig. 6 (b) shows results obtained by the method of the present invention carried out in case where a single non-crack-free crystal was used as a crystal seed. A shaped metal piece with an inside void (7) was used to cover the area with cracks and the elimination of propagation of cracks from the crystal seed to the newly grown crystal was observed.

Additionally, when the method of the invention is used in connection with the tiling method, the tiling of the seeds occurs on a small seam area of a few hundred micrometers (Fig. 6 (a)) instead of a large tiling seam area which reached a few millimeters (Fig. 5). Preferably, this area will move in time without increasing its lateral size when the crystal is grown in the [000-1] direction. Furthermore, another important factor in the tiling method is a proper mutual misorientation of the seeds. It should be performed in three planes with the angular differences not higher than 0.02°, which allows to perform the tiling procedure properly (see Fig. 2). Despite the above-described alignment with reference to crystallographic planes, it should be reminded that in order to reach optimal results by the method of the invention, the metal piece has to be placed symmetrically with reference to the crystal tiles.

Another factor regarding the correct placement of the shaped metal piece is the relation between the shaped metal piece and the area having increased crack-forming potential. The metal piece should be preferably placed on the surface of the crystal seed right above the area having increased crack-forming potential. In one embodiment, the width and length of the shaped metal piece may be larger than the area having increased crack-forming potential by approximately 0.5 mm to 2 mm.

Another condition to be fulfilled is the correct choice of the size and shape of the shaped metal piece. The possible dimensions of the metal piece have been discussed above and will not be repeated here for the sake of brevity. However, its correct choice and adjustment is essential to obtain crack-free crystal growth.

Preferably, the size, shape and length of the shaped metal piece should be adjusted to the size, shape and length of the area having increased crack-forming potential in such a way to completely cover this area. Fig. 7 shows a top view of two embodiments schematically presenting different shapes and sizes of the metal piece (1) used to perform the method of the invention.

In the first embodiment shown in Fig. 7 (a), a crack 6 area of the crystal seed 8 of length H is covered by a shaped metal piece (1) with a shape corresponding to the shape of the crack 6 area (smaller width at the ends, larger width in the center). After subjecting the crystal seed 8 to growth process a crystal 9 of length h (h<H) was produced due the formation of m edges on the shaped metal piece 1.

In another embodiment, shown in Fig. 7 (b), similar crystal seed 8 was used to perform crystal growth process, but this time the shape of the metal piece (1) was different. As a result, a crystal 9 of the same width as crystal seed 8 was obtained (h≈H).

To sum up, the choice of the shape of the metal element depends on the location, size, and number of cracks. It is advantageous to cover as little area of the seed as possible.

The method of the invention will be closer presented in the examples below, in which GaN growth process using ammonothermal conditions was carried out.

### Examples

### Example 1 (reference example, not according to invention)

In this example a single GaN crystal was grown using ammonothermal method without the shaped metal piece. A classical vertical ammonothermal growth reactor was used (see Fig. 1). The crystal growth was performed as follows:
a) A hexagonal GaN crystal having a width of 2.2 inches and thickness of about 700 µm was used as a crystal seed. The crystal seed comprised 18 cracks of size of up to 3 mm. It was placed in the crystallization zone of the reactor on a plate-like seed holder.
b) Liquid gallium (Ga) in an amount of 2.5 kg - 3 kg was placed in the upper dissolution zone of the reactor, separated from the crystallization zone by a baffle, along with 5 kg - 6 kg of ammonia. The ammonia was provided with suitable mineralizers, such as sodium (Na), in the following amounts: 200 g - 400 g.
c) The reactor was closed and subjected to ammonothermal reaction in the following conditions: pressure of 0.15 GPa - 0.45 GPa, temperature of 720 K - 920 K, with constant monitoring of the course of the reaction;
d) The reaction was finished when the source material was close to depletion, i.e., when the amount of gallium was in the range of 10-20% by weight of the initial value. The time when the reaction reaches this state was estimated based on basic research performed in the same physicochemical conditions.

The obtained crystal was carefully visually inspected for cracks. The size of each cracks was equal to 3 mm and their number was 25. The resultant crystal was also measured and its size was equal to 2.2 inches.

The resultant structural quality of the GaN crystal obtained using this method was high, but the number of cracks increased at the seam area.

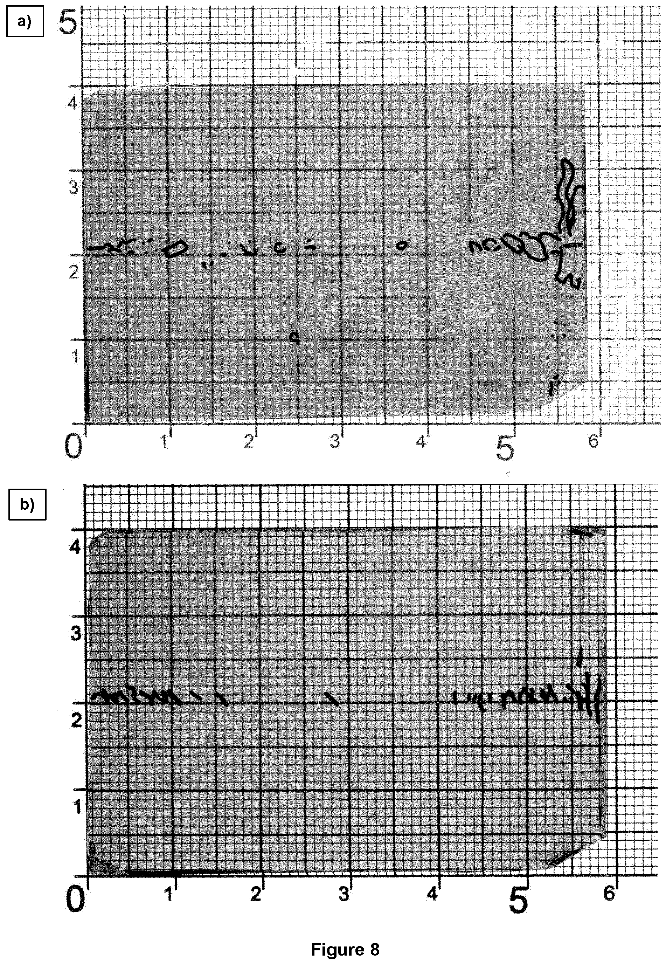

The results were also presented visually in Fig. 8, where a) shows crystal before crystal growth and b) shows the resultant crystal. Cracks are marked in both pictures by black ink. As it shown on the figure, the number of cracks increased after the growth process.

### Example 2

In the second example the GaN crystal was grown using the ammonothermal method with a metal piece made of Ni wrapped with Ag foil, of the size of 6 mm × 54 mm × 1.5 mm, and the shape as illustrated on Fig. 4d for covering cracks (defects).

The crystal growth process was performed in the same way to that described with reference to Example 1, with the only difference introduced in step a) in which defects (mainly cracks) on the crystal seed were covered by the shaped metal piece before placing the seed in the crystallization zone of the reactor.

The obtained crystal was carefully visually inspected for cracks and other macro-defects. The results of the visual inspection showed no defects. The resultant crystal was also measured and its lateral size was 2.2 inches. The crystal's thickness was about 3 mm. It was similar to the crystal obtained in Example 1.

The resultant structural quality of the GaN crystal was very high. All of the cracks in the area covered by the metal element were removed.

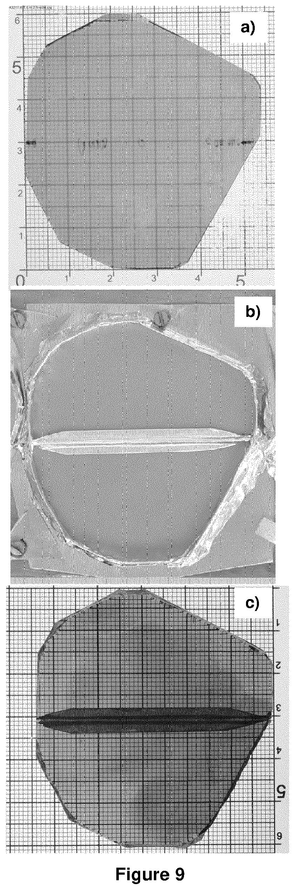

The results were also presented visually in Fig. 9, where a) bare crystal before crystal growth, b) presents the crystal provided with a shaped metal piece also before crystal growth, and c) presents the resultant crystal. Cracks are marked in picture a) by black ink and it can be clearly seen that there are no cracks in the resultant crystal.

### Example 3 (reference example, not according to invention)

This example illustrates a method of the invention including crystal tiling of GaN crystals without using the shaped metal piece. The tiled crystal seeds (two GaN crystals, each having the dimensions of 25 mm × 67 mm and thickness of 800 µm - 900 µm) were used in an ammonothermal process with conditions as described in Example 1. The resultant crystal was measured, and its size was 50 mm × 60 mm and the thickness was 2.5 mm.

The obtained crystal was also carefully visually inspected for macro defects, such as cracks. The resultant structural quality of the GaN crystal obtained using this method was high, but the number of cracks at the tiling seam was equal to 8.

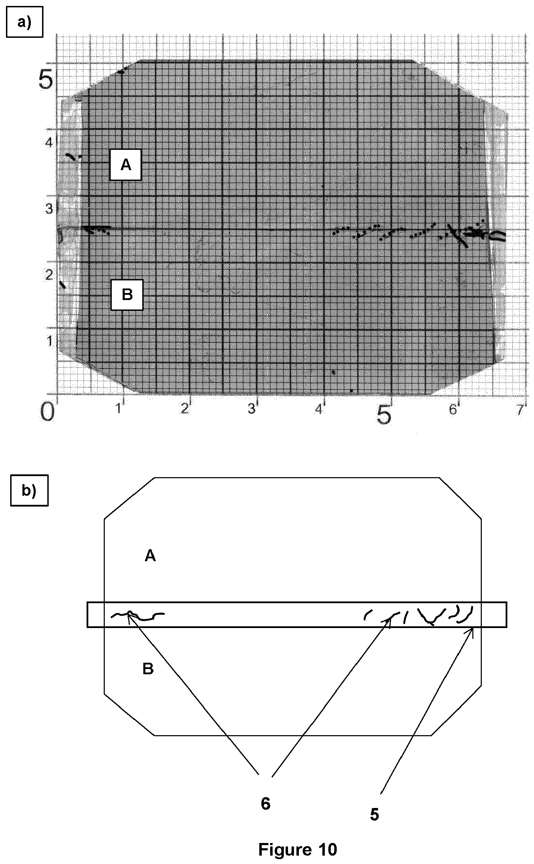

The appearance of cracks 6 directly above the tiling seam 5 of the neighboring crystals A and B could be easily observed in Fig. 10, where a) is a real photo of the resultant crystal and b) is its simplified illustration presented for the sake of clarity. Cracks 6 are marked in picture a) by black ink.

### Example 4

The process of this example was carried out in the same manner as in Example 3, however this time a shaped metal piece made of Ag foil with the size of 2 mm × 67 mm × 0.05 mm and the shape as illustrated in Fig. 4e was used to completely cover the joint line of the tiled crystal seeds. The tiled crystal seeds (two GaN crystals, each with the size of 25 mm × 67 mm and thickness of 800 µm - 900 µm) were used in the ammonothermal process with conditions as described in Example 1.

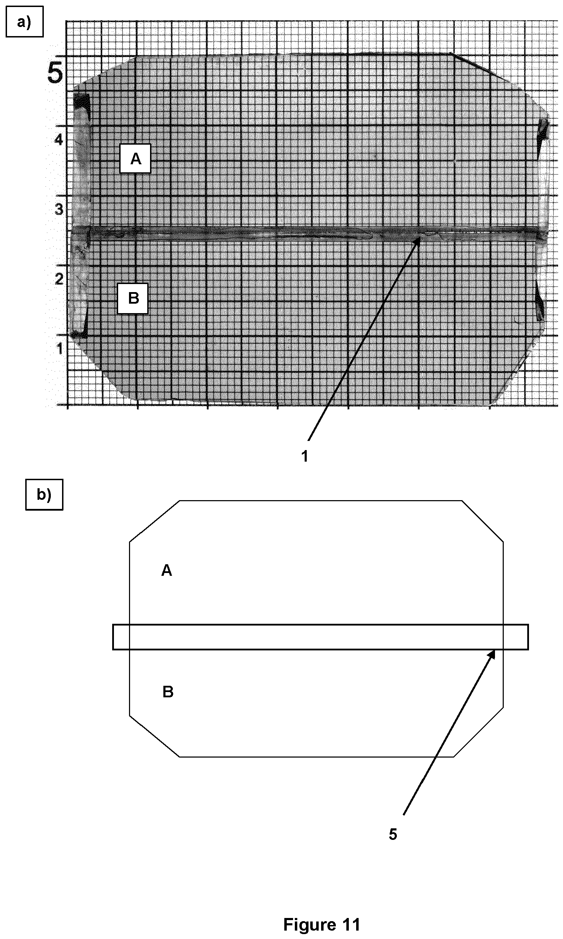

The obtained crystal (see Fig. 11) was carefully visually inspected for macro-defects. The results of the visual inspection showed no defects at the seam line. The resultant crystal was also measured, and its size was 50 mm × 62 mm × 2.5 mm. The size was similar to the crystal obtained in Example 3.

The resultant structural quality of the GaN crystal obtained from tiling the seeds was very high; there were no cracks (macro-defects) in the tiling seam area.

The results were also presented visually in Fig. 11, where a) is a real photo of the resultant crystal and b) is its simplified illustration presented for the sake of clarity. In picture a) the metal shaped element 1 can be observed, covering the tiling seam 5 of the neighboring crystals A and B. It can be clearly seen that there are no cracks in the resultant crystal.

The above-mentioned results of Examples 2 and 4 confirm that the quality of the newly grown crystal was greatly improved when the shaped metal piece was used. This confirms the unexpected and advantageous technical effects of the present invention.

## Claims

1. A method for reducing or eliminating cracks during a crystal growing process, wherein before a crystal seed undergoes a growth process a shaped metal piece is placed on the crystal seed over an area with increased crack-forming potential, in such a way that the shaped metal piece fully covers the whole area with increased crack-forming potential.

2. The method according to claim 1, wherein the crystal growing process includes crystal tiling method and the shaped metal piece is placed over a joint line of adjacent crystal tiles.

3. The method according to claim 2, wherein the shaped metal piece contains a substantially vertical protrusion which is at least partially inserted into the joint line between the adjacent crystal tiles.

4. The method according to claim 2, wherein the substantially vertical protrusion is formed by at least one layer of metal foil wrapped around the shaped metal piece.

5. The method according to claim 1, wherein the crystal growing process employs a single crystal seed and the shaped metal piece is placed on the surface of the crystal seed over the area having increased crack-forming potential.

6. The method according to claim 1 to 5, wherein the shaped metal piece is made of metal selected from the group including nickel, silver, molybdenum, titanium and tungsten or metal alloy selected from the group including Ag-Cu, Ag-Ni, Ag-Ti, Cu-Ni, Cu-Ti, Ni-Ti.

7. The method according to claims 6, wherein the shaped metal piece is wrapped with a metal foil, preferably made from metal selected from group including Ag-Cu, Ag-Ni, Ag-Ti, Cu-Ni, Cu-Ti, Ni-Ti.

8. The method according to claims 1 to 7, wherein the shaped metal piece has an inside void.

9. The method according to claims 1 to 8, wherein the crystal growing process is an ammonothermal process.

10. The method according to claims 1 to 8, wherein the crystal growing process is a HVPE process.

11. The method according to claims 1 to 10, wherein the crystal is gallium nitride (GaN).

12. A shaped metal piece (1) in a form of elongated pipe-like element comprising an upper convex part (2) and essentially flat bottom part (3), wherein the upper convex part (2) and the essentially flat bottom part (3) define an inside void (7) of the shaped metal piece, and wherein the essentially flat bottom part (3) has an essentially vertical protrusion (4) extending downwards from the essentially flat bottom part (3).

13. A shaped metal piece according to claim 12, wherein the upper convex part (2) has a hemispherical or triangle cross section or their combination.

14. A shaped metal piece according to claim 12 or 13, wherein the cross section of the shaped metal piece (1) is constant along its length.

15. A shaped metal piece according to claim 12 or 13 wherein the cross section of the shaped metal piece (1) varies along its length.
